# EUROPÄISCHE PATENTSCHRIFT

(11) **EP 2 732 295 B1**
(45) Veröffentlichungstag und Bekanntmachung des Hinweises auf die Patenterteilung: **29.04.2015**
(21) Anmeldenummer: 12737267.0
(22) Anmeldetag: 13.07.2012
(51) Int. Cl.: G01R 19/00, G01R 31/36, G01R 1/20, G01R 15/20

(54) **VORRICHTUNG ZUM MESSEN EINES ELEKTRISCHEN STROMES**
CURRENT MEASURING DEVICE
APPAREIL DE MESURE DE COURANT

(30) Priorität: 14.07.2011 DE 102011079176
(43) Veröffentlichungstag der Anmeldung: 21.05.2014
(73) Patentinhaber: Continental Teves AG & Co. oHG, 60488 Frankfurt (DE)
(72) Erfinder: JÖCKEL, Wolfgang, 36129 Gersfeld (DE); RINK, Klaus, Rodenbach 63517 (DE)
(86) Internationale Anmeldenummer: PCT/EP2012/063856
(87) Internationale Veröffentlichungsnummer: WO 2013/007833

(56) Entgegenhaltungen:
- EP-A1- 1 213 189
- EP-A1- 2 068 402
- DE-A1- 10 240 243
- DE-A1-102004 007 851
- DE-C1- 19 526 870

## Beschreibung

Die Erfindung betrifft eine Vorrichtung zum Messen eines elektrischen Stromes zwischen einer Fahrzeugbatterie und einen an die Fahrzeugbatterie angeschlossenen elektrischen Verbrauchers, ein Fahrzeug mit der Vorrichtung, ein Verfahren zum Messen eines elektrischen Stromes zwischen einer Fahrzeugbatterie und einen an die Fahrzeugbatterie angeschlossenen elektrischen Verbrauchers sowie eine Vorrichtung zur Durchführung des Verfahrens.

Zur Durchführung von Messungen eines von einer elektrischen Energiequelle an einen elektrischen Verbraucher abgegebenen elektrischen Stromes in einem Kraftfahrzeug kann in Reihe zwischen die elektrische Energiequelle und den elektrischen Verbraucher ein Stromsensor geschaltet werden. Ein derartiger Stromsensor ist beispielsweise aus der DE 10 2011 078 548 A1, EP 1 213 189 A1 oder EP 2 068 402 A1 bekannt.

Es ist Aufgabe der vorliegenden Erfindung die Strommessungen zu verbessern.

Die Aufgabe wird durch die Merkmale der unabhängigen Ansprüche gelöst. Bevorzugte Weiterbildungen sind Gegenstand der abhängigen Ansprüche.

Die Erfindung schlägt eine Vorrichtung zum Messen eines elektrischen Stromes zwischen einer Fahrzeugbatterie und einen an die Fahrzeugbatterie angeschlossenen elektrischen Verbrauchers vor, wobei der Strom über zwei redundante Stromsensoren gemessen wird.

Der Erfindung liegt die Überlegung zugrunde, dass in Elektro- und Hybridfahrzeugen wichtig ist, möglichst genaue Informationen über die noch zur Verfügung stehende Energie bis zum nächsten Aufladen, also den Ladezustand, zu haben, um zum Einen unterwegs nicht liegenzubleiben, und um zum Anderen durch ein entsprechendes Energiemanagement eine ohnehin mit der zur Verfügung stehenden Energie fahrbare, geringe Reichweite zu optimieren.

Zwar ließe sich je nach Typ einer im Fahrzeug verwendeten Fahrzeugbatterie ihr Ladezustand bereits mittels einer Spannungsmessung bestimmen. Alternativ könnte der Ladezustand aber auch über eine Ladungsberechnung beim Laden und Entladen der Fahrzeugbatterie bestimmt werden. Dieser Berechnung liegt die Berechnung der Ladungsmenge basierend auf der Gleichung Q=I*t zugrunde, wozu jedoch eine präzise Strommessung notwendig wäre.

Diese Überlegung zugrunde gelegt, liegt der Erfindung die Idee zugrunde, dass sich aufgrund der notwendigen zeitlichen Integration bei der Berechnung der Ladungsmenge Fehler in der Stromerfassung potentieren und zu völlig falschen Ladungszuständen für die Batterie führen können. Daher schlägt die Erfindung vor, die Stromerfassung nicht mit einem einzelnen Stromsensor sondern mit zwei verschiedenen Stromsensoren durchzuführen.

Die Erfindung gibt daher eine Vorrichtung zum Messen eines elektrischen Stromes zwischen einer Fahrzeugbatterie und einen an die Fahrzeugbatterie angeschlossenen elektrischen Verbrauchers an, die eine den elektrischen Strom aus der Fahrzeugbatterie aufnehmende und an den elektrischen Verbraucher weiterleitende Sammelschiene, nachstehend auch Stromschiene genannt, umfasst, auf der ein erster Stromsensor und vom ersten Stromsensor verschiedener zweiter Stromsensor angeordnet sind, die eingerichtet sind, den elektrischen Strom durch die Sammelschiene unabhängig voneinander zu messen.

Auf diese Weise wird der zu messende Strom redundant erfasst, was die Fehlerrate bei der Strommessung senkt und so zu einer deutlich genaueren Erfassung des Ladezustandes der Fahrzeugbatterie führt.

Da die Strommessung auch der Bestimmung des sogenannten "Gesundheitszustandes", SOH (State of Health) genannt sowie des sogenannten "Funktionszustandes", SOF (State of Function) genannt dient, können mit der angegebenen Vorrichtung auch verschiedenste weitere Systemfunktionen eines Fahrzeugbatterie-Management Systems verbessert werden, wie zum Beispiel:
- das Abschalten bzw. Herunterregeln von elektrischen Verbrauchern bis hin zum Stilllegen des Fahrzeuges vor bzw. beim Erreichen einer Mindest- Ladungsmenge in der Antriebsbatterie,
- das Abschalten beziehungsweise Herunterregeln des Ladevorgangs bei Erreichen einer maximalen Ladungsmenge zum Beispiel beim Rekuperieren bei bereits vollständig geladener Fahrzeugbatterie,
- das Begrenzung des Laststroms durch Kontrolle eines Entladestroms der Fahrzeugbatterie um eine dauerhafte Beschädigung der Batteriezellen zu vermeiden,
- die Überwachung des Ladestroms um eine Beschädigung der Zellen durch zu große Ladeströme zu verhindern,
- das Auftrennen des Strompfades zwischen der Fahrzeugbatterie und dem elektrischen Verbraucher beziehungsweise der elektrischen Energiequelle bei Erkennung eines definierten Überstrompegels für eine bestimmte zeitliche Mindestdauer und
- das Erkennen von Leckströmen bei abgestelltem Fahrzeug wenn die Zündung des Fahrzeuges abgestellt ist.

In einer Weiterbildung der angegebenen Vorrichtung weist der erste Stromsensor ein vom zweiten Stromsensor unabhängiges Messprinzip auf. Auf diese Weise können die Zuverlässigkeit der redundant ausgebildeten Stromsensoren weiter gesteigert werden, da die verschiedenen Messprinzipien unterschiedlich anfällig auf verschiedene äußere Einflüsse, wie Temperatur-oder Druckschwankungen sind.

In einer anderen Weiterbildung der angegebenen Vorrichtung umfasst die Stromschiene eine Leiterschleife, in der der erste Stromsensor den zu messenden Strom basierend auf einem magnetischen Messprinzip erfasst. Auf diese Weise kann ein erstes der Messprinzipe auf einfache Weise umgesetzt werden.

In einer zusätzlichen Weiterbildung der angegebenen Vorrichtung weist die Leiterschleife eine elektrische Unterbrechung auf, die vom zweiten Stromsensor überbrückt ist, wobei der zweite Stromsensor als Shunt ausgebildet ist. Auf diese Weise können die beiden in ihren Messprinzipien verschiedenen Stromsensoren mit einer hohen Packungsdichte auf einer einzigen Stromschiene untergebracht werden, da die Unterbrechung der Stromschiene durch den Shunt geschlossen wird und so keine Auswirkungen auf die Messung mit dem magnetischen Sensor hat. Die resultierende Vorrichtung kann auf diese Weise mit geringsten Abmessungen einstückig zwischen die Fahrzeugbatterie und den Verbraucher austauschbar geschaltet werden, so dass beispielsweise beim Erkennen einer fehlerhaften Strommessung, wenn die Messergebnisse beider Stromsensoren voneinander differieren, die Vorrichtung zeitnah ersetzt werden kann.

In einer besonderen Weiterbildung der angegebenen Vorrichtung ist ein durch den zu messenden elektrischen Strom verursachter Spannungsabfall über dem Shunt durch eine Steuerspannung konstant haltbar, so dass die Steuerspannung abhängig vom zu messenden elektrischen Strom ist. Der entsprechende aktive Shunt sollte zweckmäßigerweise so ausgebildet sein, dass über eine nichtlineare Kennlinie die Auflösung des Messwertes vom zum messenden Stromes abhängig realisiert werden könnte und somit eine Messung über einen hohen Dynamikbereich mithilfe von Standardbauteilen für die Signalkonditionierung ermöglicht wird. Dazu könnte der aktive Shunt beispielsweise eine umgekehrt proportionale Kennlinie aufweisen, wodurch die Auflösung des Messwertes des zu messenden Stromes bei größeren Strömen gröber wird. Als aktiver aktiven Shunt könnte beispielsweise ein Feldeffekttransistor gewählt werden.

In einer anderen Weiterbildung der angegebenen Vorrichtung unterteilt die elektrische Unterbrechung die Leiterschleife in zwei voneinander elektrisch getrennte Leiterschleifenschenkel, wobei die beiden Leiterschleifenschenkel in der angegebenen Vorrichtung gestapelt sind. Auf diese Weise kann die Packungsdichte weiter erhöht werden, da sich die Leiterschleife auf diese Weise nicht nur in die Fläche sondern auch in eine Höhe erstrecken kann.

In einer besonders bevorzugten Weiterbildung der angegebenen Vorrichtung sind die gestapelten Leiterschleifenschenkel über eine elektrisch isolierende mechanische Verbindung verbunden miteinander, die von einer Verbindung über den Shunt verschieden ist. Auf diese Weise wird ein besonders großer mechanischer Halt zwischen den beiden Leiterschleifenschenkeln erzielt, der nicht von der elektrischen Verbindung über den Shunt bereitgestellt werden muss, so dass die elektrische Verbindung beständiger und damit fehlerunanfälliger ist.

Die Erfindung gibt auch eine Fahrzeugbatterie an, die einen elektrischen Anschluss zum Abgeben oder Aufnehmen eines elektrischen Stromes an einen elektrischen Verbraucher beziehungsweise von einer elektrischen Energiequelle und eine angegebene Vorrichtung umfasst, die an den elektrischen Anschluss angeschlossen ist.

Die Erfindung gibt auch ein Fahrzeug an, das eine Fahrzeugbatterie, einen elektrischen Verbraucher und eine der angegebenen Vorrichtungen, die zwischen den elektrischen Verbraucher und die Fahrzeugbatterie geschaltet ist, umfasst.

Die Erfindung gibt auch ein Verfahren zum Erfassen eines Messwertes für einen elektrischen Strom zwischen einer Fahrzeugbatterie und einen an die Fahrzeugbatterie angeschlossenen elektrischen Verbraucher an, das die folgenden Schritte umfasst:
- Erfassen eines ersten Wertes für den elektrischen Strome mit einem ersten Stromsensor,
- Erfassen eines Wertes für den elektrischen Strome mit einem vom ersten Stromsensor verschiedenen zweiten Stromsensor, und
- Bestimmen des Messwertes für den elektrischen Strom basierend auf dem ersten und zweiten Wert.

Das angegebene Verfahren ist beliebig derart weiterbar, dass mit einer Vorrichtung gemäß den Unteransprüchen sinngemäß durchführbar ist.

Die Erfindung gibt auch eine Steuervorrichtung an, die eingerichtet ist, ein Verfahren nach einem der vorstehenden Ansprüche durchzuführen.

In einer Weiterbildung der Erfindung weist die angegebene Vorrichtung einen Speicher und einen Prozessor auf. Dabei ist das angegebene Verfahren in Form eines Computerprogramms in dem Speicher hinterlegt und der Prozessor zur Ausführung des Verfahrens vorgesehen, wenn das Computerprogramm aus dem Speicher in den Prozessor geladen ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines ersten Ausführungsbeispiels der angegebenen Vorrichtung,
Fig. 2 eine schematische Ansicht eines zweiten Ausführungsbeispiels der angegebenen Vorrichtung, und
Fig. 3 eine schematische Ansicht eines dritten Ausführungsbeispiels der angegebenen Vorrichtung.

In den Figuren werden gleiche technische Elemente mit gleichen Bezugszeichen versehen und nur einmal beschrieben.

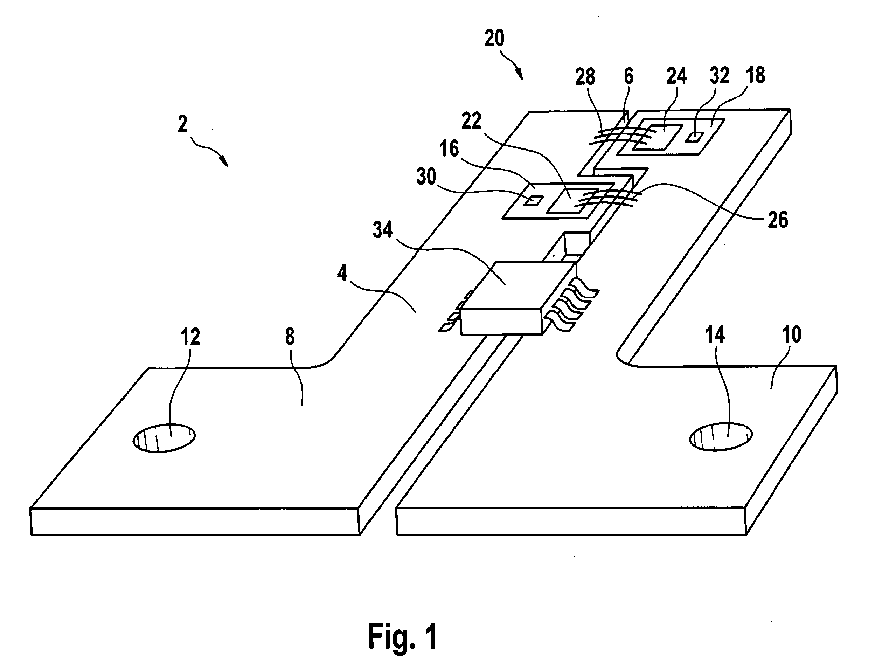

Es wird auf Fig. 1 Bezug genommen, die eine schematische Ansicht eines ersten Ausführungsbeispiels der angegebenen Vorrichtung 2 zeigt.

Die Vorrichtung 2 weist in der vorliegenden Ausführung eine Sammelschiene 4 mit einer elektrischen Unterbrechung 6 auf, die die Sammelschiene 4 in zwei Sammelschienenteile 8, 10 teilt. Jedes Sammelschienenteil 8, 10 ist in der vorliegenden Ausführung rechtwinklig abgebogen, so dass die Sammelschiene 4 beim Zusammensetzen der beiden Sammelschienenteile eine im Wesentlichen U-förmige Leiterschleife bildet. Jedes der Sammelschienenteile 8, 10 kann über je eine Durchgangsbohrung 12, 14 an einer nicht weiter dargestellten Fahrzeugbatterie beziehungsweise an einem nicht weiter dargestellten Verbindungskabel befestigt werden, das einen elektrischen Verbraucher oder einen elektrischen Generator im Fahrzeug mit der Sammelschiene 4 verbindet. Damit wird die Sammelschiene 4 in Reihe zwischen das Verbindungskabel und die Fahrzeugbatterie geschaltet.

Auf dem ersten und dem zweiten Sammelschienenteil 8, 10 ist jeweils ein aus der DE 10 2011 078 548 A1 bekannter Leistungsfeldeffekttransistor 16, 18 nachstehend FET 16, 18 genannt, getragen, der Teil eines in der genannten Druckschrift offenbarten aktiven Shunts 20 ist. Ein in der vorliegenden Darstellung nicht weiter sichtbare Source-Anschluss des ersten FETS 16 und ein in der vorliegenden Darstellung nicht weiter sichtbarer Drain-Anschluss des zweiten FETs 18 sind in der vorliegenden Ausführung jeweils mit den Sammelschienenteilen 8, 10 elektrisch kontaktiert, auf denen die FETs 16, 18 getragen sind. Ein Drain-Anschluss 22 des ersten FETs 16 und ein Source-Anschluss 24 des zweiten FETs 18 ist jeweils an Bond-Drähte 26, 28 angeschlossen. Mit der elektrischen Bond-Drähten 26, 28 wird der freie Source- beziehungsweise Drain-Anschluss 22, 24 eines FETs 16, 18 jeweils mit dem Sammelschienenteil 8, 10 elektrisch verbunden, auf dem der entsprechende FET 16, 18 nicht getragen ist. Auf diese Weise überbrücken die FETs 16, 18 gemeinsam mit den Bond-Drähten 26, 28 die beiden Sammelschienenteile 8, 10 und stellen so einen geschlossenen Strompfad über die Sammelschiene 4 her.

Wie in der DE 10 2011 078 548 A1 näher erläutert, sind die beiden FETs 16, 18 zwischen den beiden Sammelschienenteilen 8, 10 verschaltet, um einen durch die Sammelschiene 4 fließenden Strom in zwei verschiedene Stromrichtungen zu messen. Dazu sind an die Gate-Anschlüsse 30, 32 der FETs 16, 18 eine nicht weiter dargestellte Auswerteschaltung angeschlossen, deren Aufbau sich beispielsweise an dem in der DE 10 2011 078 548 A1 offenbarten Aufbau orientieren kann.

Der zwischen die beiden Sammelschienenteilen 8, 10 verschaltete aktive Shunt 20 soll in der vorliegenden Ausführung beispielhaft einen Stromsensor darstellen, der beispielsweise zum Messen eines Lade- und Entladestromes zu oder aus einer Fahrzeugbatterie herangezogen werden könnte. Alternativ kann zwischen den beiden Sammelschienenteilen 8, 10 auch ein passiver Shunt verschaltet werden.

Der aktive Shunt 20 überbrückt in der vorliegenden Ausführung die elektrische Unterbrechung 6 zwischen den Sammelschienenteilen 8, 10 an einem der Enden der Sammelschienenteile 8, 10. Vom aktiven Shunt 20 aus gesehen wird die elektrische Unterbrechung 6 zwischen den Sammelschienenteilen 8, 10 zusätzlich unterhalb des aktiven Shunts von einem magnetfeldbasierten Stromsensor 34 überbrückt. Der magnetfeldbasierte Stromsensor 34 kann beispielsweise ein magnetoresistiver Stromsensor sein, der in einer dem Fachmann bekannten Weise einen magnetischen Widerstand der Stromschiene 4 erfassen kann, wobei der erfasste magnetische Widerstand vom elektrischen Strom abhängig ist, der Leiterschleife und damit die Stromschiene 4 durchdringt. Alternativ kann der magnetfeldbasierte Stromsensor 34 auch ein Hall-Sensor sein. Somit kann mit dem magnetfeldbasierten Stromsensor 34 der elektrische Strom durch die Stromschiene 4 redundant erfasst werden.

Aus Sicht des magnetfeldbasierenden Stromsensors 34 wird in der vorliegenden Ausführung in die für die magnetfeldbasierenden Erfassung des die Stromschiene 4 durchströmenden elektrischen Stromes ohnehin notwendige Leiterschleife eine elektrische Unterbrechung 6 eingebracht, die vom als aktiver Shunt 20 ausgebildeten Shunt elektrisch überbrückt und zur redundanten Messung des die Stromschiene 4 durchströmenden elektrischen Stromes verwendet wird.

In der vorliegenden Ausführung greifen die beiden Stromschienenteile 8, 10 an der elektrischen Unterbrechung 6 zahnförmig ineinander, so dass an dieser Stelle neben den gezeigten FETs 16, 18 weitere FETs zum Messen des elektrischen Stromes durch die Stromschiene 4 angeordnet werden könnten.

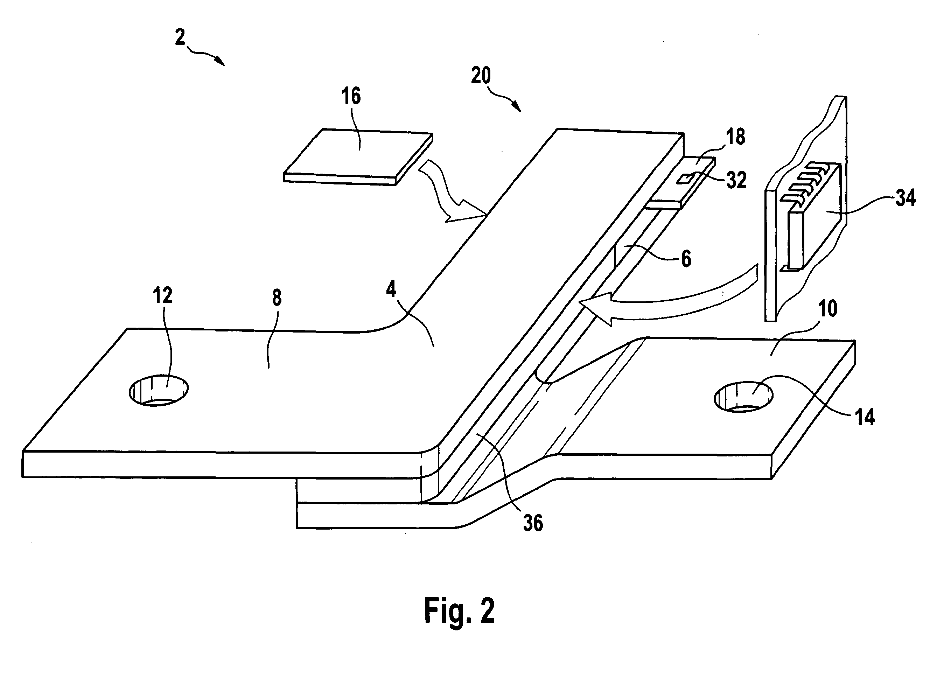

Es wird auf Fig. 2 Bezug genommen, die eine schematische Ansicht eines zweiten Ausführungsbeispiels der Vorrichtung 2 zeigt.

In Fig. 2 wird die Stromschiene 4 aus den Stromschienenteilen 8, 10 durch stapeln der Stromschienenteile 8, 10 statt durch nebeneinanderlegen gebildet. Auf diese Weise bieten die Stromschienenteile 8, 10 eine ausreichende Fläche, um in der elektrischen Unterbrechung 6 ein mechanisches Verbindungsmittel 36, wie beispielsweise einen Klebstoff aufzunehmen, der die beiden Stromschienenteile 8, 10 mechanisch zusammenhält.

Dies hat nicht nur den Vorteil, dass die Stromschiene 4 einen besseren mechanischen Halt aufweist, die beiden FETs 16, 18 können nun auch direkte über ihre Oberseite und ihre Unterseite mit dem Source-Anschluss beziehungsweise dem Drain-Anschluss der FETs 16, 18 kontaktiert werden, so dass die Bond-Drähte 26, 28 obsolet sind. Mit den wegfallenden Bond-drähten 26, 28 fallen zudem auch elektrische Kontaktierungsstellen zum Kontaktieren dieser Bond-Drähte 26, 28 weg, wodurch der elektrische Widerstand durch die Stromschiene 4 in der vorliegenden Ausführung besonders niedrig ist.

In der vorliegenden Ausführung wird der erste FET 16 mit einer bestimmten Orientierung zwischen die beiden Stromschienenteile 8, 10 eingesetzt, während der zweite FET 10 mit genau der umgekehrten Orientierung zwischen die beiden Stromschienenteile 8, 10 eingesetzt wird, um die oben erwähnte Erfassung des Stromes durch die Stromschiene 4 in beiden Richtungen zu ermöglichen. Schlussendlich ragen von den FETs 16, 18 lediglich noch die Gate-Anschlüsse 30, 32 aus dem Stapel der Stromschienenteile 8, 10 hervor, über die die FETs 16, 18 mit der oben genannten nicht weiter dargestellten Auswerteschaltung elektrisch kontaktiert werden können.

Der magnetfeldbasierenden Sensor 34 kontaktiert die beiden Stromschienenteile 8, 10 in der vorliegenden Ausführung seitlich an der Stromschiene 4.

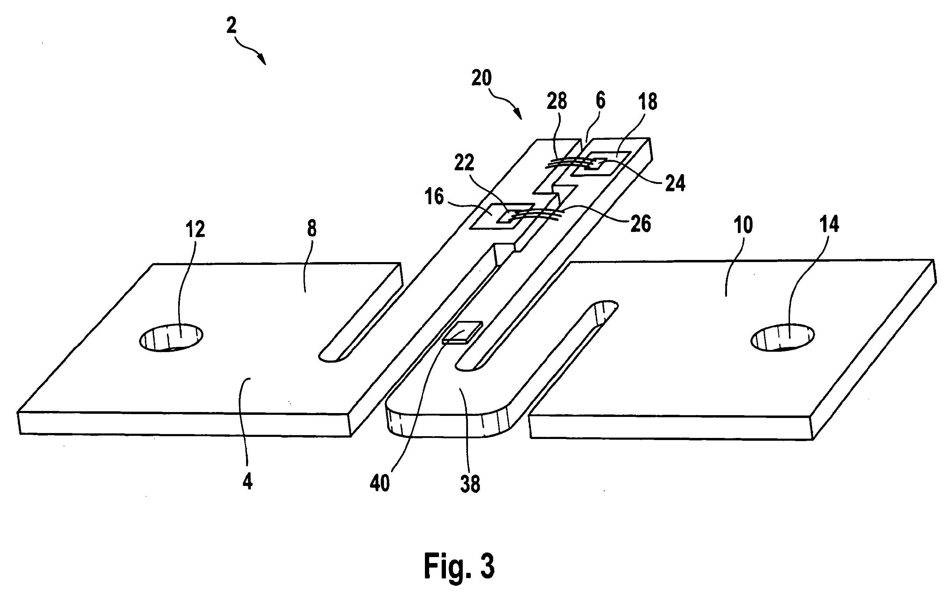

Es wird auf Fig. 3 Bezug genommen, die eine dritte Ausführung der Vorrichtung 2 zeigt.

In der vorliegenden Ausführung weist das zweite Stromschienenteil 10 gegenüber dem ersten Stromschienenteil 8 der Vorrichtung 2 eine zusätzliche Windung 38 auf. Auf dieser Windung 38 ist in der vorliegenden Ausführung ein Hallsensor 40 elektrisch kontaktiert, der in einer dem Fachmann bekannten Weise ein durch die Stromschiene 4 erzeugtes magnetisches Feld gemessen wird, das in einer dem Fachmann bekannten Weise vom den die Stromschiene 4 durchströmenden elektrischen Strom abhängig ist, so dass sich mit dem Hall-Sensor 40 der Strom durch die Stromschiene 4 erfassen lässt. Auch in der vorliegenden Ausführung weist die Stromschiene 4 damit eine Leiterschleife auf, die hier mehrere Windungen umfasst, wobei die Leiterschleife an einer Stelle eine elektrische Unterbrechung aufweist, die von einem Shunt, der hier ein aktiver Shunt 20 ist, elektrisch überbrückt wird.

Auf diese Weise wird zur Strommessung durch die Stromschiene 4 lediglich der Platz benötigt, der ohnehin zum Erfassen des Stromes auf Magnetfeldbasis notwendig wäre, wobei die redundante Implementierung des zusätzlichen Stromsensors in Form eines Shunts nahezu platzneutral erfolgt.

## Patentansprüche

1. Vorrichtung (2) zum Messen eines elektrischen Stromes zwischen einer Fahrzeugbatterie und einen an die Fahrzeugbatterie angeschlossenen elektrischen Verbraucher, umfassend eine den elektrischen Strom aus der Fahrzeugbatterie aufnehmende und an den elektrischen Verbraucher weiterleitende Sammelschiene (4), auf der ein erster Stromsensor (34, 40) und vom ersten Stromsensor (34, 40) verschiedener zweiter Stromsensor (20) angeordnet sind, die eingerichtet sind, den elektrischen Strom durch die Sammelschiene (4) unabhängig voneinander zu messen, wobei
die Sammelschiene (4) eine Leiterschleife umfasst, in der der erste Stromsensor (34, 40) den zu messenden Strom basierend auf einem magnetischen Messprinzip erfasst,
**dadurch gekennzeichnet, dass**
die Leiterschleife eine elektrische Unterbrechung (6) aufweist, die vom zweiten Stromsensor (20) überbrückt ist, wobei der zweite Stromsensor (20) als Shunt ausgebildet ist und wobei
ein durch den zu messenden elektrischen Strom verursachter Spannungsabfall über dem Shunt (20) durch eine Steuerspannung konstant haltbar ist, so dass die Steuerspannung abhängig vom zu messenden elektrischen Strom ist.

2. Vorrichtung (2) nach Anspruch 1, wobei der erste Stromsensor (34, 40) mit einem vom zweiten Stromsensor (20) unabhängigen Messprinzip betrieben wird.

3. Vorrichtung (2) nach einem der Ansprüche 1 oder 2, wobei die elektrische Unterbrechung (6) die Leiterschleife in zwei voneinander elektrisch getrennte Leiterschleifenschenkel (8, 20) unterteilt, die gestapelt sind.

4. Vorrichtung (2) nach Anspruch 3, wobei die gestapelten Leiterschleifenschenkel (8, 10) über eine elektrisch isolierende mechanische Verbindung (36) miteinander verbunden sind, die von einer Verbindung über den Shunt (20) verschieden ist.

5. Fahrzeugbatterie umfassend
- einen elektrischen Anschluss zum Abgeben oder Aufnehmen eines elektrischen Stromes an einen elektrischen Verbraucher beziehungsweise von einer elektrischen Energiequelle, und
- eine Vorrichtung (2) nach einem der vorstehenden Ansprüche, die an den elektrischen Anschluss angeschlossen ist.

## Claims

1. Device (2) for measuring an electric current between a vehicle battery and an electrical consumer connected to the vehicle battery, said device comprising a busbar (4), which receives the electric current from the vehicle battery and transfers it to the electrical consumer and on which a first current sensor (34, 40) and a second current sensor (20), which is different from the first current sensor (34, 40), are arranged, said current sensors being configured to measure the electric current through the busbar (4) independently of one another, wherein
the busbar (4) comprises a conductor loop, in which the first current sensor (34, 40) detects the current to be measured on the basis of a magnetic measuring principle,
**characterized in that**
the conductor loop has an electrical interruption (6) which is bridged by the second current sensor (20), wherein the second current sensor (20) is designed as a shunt and wherein
a voltage drop, caused by the electric current to be measured, across the shunt (20) can be kept constant by a control voltage, with the result that the control voltage is dependent on the electric current to be measured.

2. Device (2) according to Claim 1, wherein the first current sensor (34, 40) is operated using a measuring principle which is independent of the second current sensor (20).

3. Device (2) according to either of Claims 1 and 2, wherein the electrical interruption (6) divides the conductor loop into two conductor-loop limbs (8, 10) which are electrically isolated from one another and are stacked.

4. Device (2) according to Claim 3, wherein the stacked conductor-loop limbs (8, 10) are connected to one another via an electrically isolating mechanical connection (36), which is different from a connection via the shunt (20).

5. Vehicle battery comprising
- an electrical connection for outputting an electric current to an electrical consumer or, respectively, for receiving an electric current from an electrical energy source, and
- a device (2) according to one of the preceding claims, said device being connected to the electrical connection.

## Revendications

1. Ensemble (2) de mesure du courant électrique qui s'écoule entre une batterie de véhicule et un consommateur électrique raccordé à la batterie du véhicule, l'ensemble comportant
un rail collecteur (4) qui reprend le courant électrique dans la batterie du véhicule et le transmet au consommateur électrique et sur lequel un premier capteur de courant (34, 40) et un deuxième capteur de courant (20) différent du premier capteur de courant (34, 40) sont disposés et sont conçus pour mesurer le courant électrique qui s'écoule dans le rail de courant (4) indépendamment l'un de l'autre,
le rail collecteur (4) comportant une boucle conductrice dans laquelle le premier de courant (34, 40) saisit le courant à mesure sur la base d'un principe de mesure magnétique,
**caractérisé en ce que**
la boucle conductrice présente une interruption électrique (6) pontée par le deuxième capteur de courant (20), le deuxième capteur de courant (20) étant configuré comme shunt,
**en ce que** la chute de tension aux bornes du Shunt (20) provoquée par le courant électrique à mesurer peut être maintenue constante par une tension de commande et
**en ce que** la tension de commande est indépendante du courant électrique à mesurer.

2. Ensemble (2) selon la revendication 1, dans lequel le premier capteur de courant (34, 40) est utilisé avec un principe de mesure indépendant du deuxième capteur de courant (20).

3. Ensemble (2) selon l'une des revendications 1 ou 2, dans lequel l'interruption électrique (6) divise la boucle conductrice en deux branches (8, 20) de boucle conductrice séparées électriquement l'une de l'autre et empilées.

4. Ensemble (2) selon la revendication 3, dans lequel les branches (8, 10) empilées de boucle conductrice sont raccordées l'une à l'autre au moyen d'une liaison mécanique (36) électriquement isolante différente de la liaison par l'intermédiaire du shunt (20).

5. Batterie de véhicule comprenant :
une borne électrique délivrant un courant électrique à un consommateur électrique ou reprenant le courant d'une source d'énergie électrique et
un dispositif (2) selon l'une des revendications précédentes, raccordé à la borne électrique.
